# EUROPEAN PATENT APPLICATION

(11) **EP 4 765 550 A1**
(43) Date of publication of application: **24.06.2026**
(21) Application number: 25216072.6
(22) Date of filing: 14.11.2025
(51) Int. Cl.: H02J 3/38, H02J 9/06

(54) **BACKUP POWER SYSTEM, AND METHOD FOR DETECTING TURN-ON OF MANUAL BYPASS CIRCUIT BREAKER**

(30) Priority: 10.12.2024 CN 202411815343
(71) Applicant: Huawei Technologies Co., Ltd., Shenzhen, Guangdong 518129 (CN)
(72) Inventor: ZHANG, Peng, Shenzhen, 518129 (CN); ZHU, Dili, Shenzhen, 518129 (CN); WEN, Jun, Shenzhen, 518129 (CN); SU, Bing, Shenzhen, 518129 (CN); WANG, Gang, Shenzhen, 518129 (CN)
(74) Representative: Gill Jennings & Every LLP

(57) **Abstract**

This application pertains to the field of power electronics technologies, and provides a backup power system and a method for detecting turn-on of a manual bypass circuit breaker. In the solutions provided in this application, on a premise that an on/off-grid relay in an on/off-grid controller is turned off, if detecting that a difference between voltages at two ends of the manual bypass circuit breaker (namely, a bypass air switch) is less than a second threshold, a control circuit can determine that a voltage at an inverter-side port of the on/off-grid controller and a voltage at a power grid-side port are close. In this case, if both the voltage at the inverter-side port and the voltage at the power grid-side port are greater than a first threshold, and if detecting that an inverter is in a non-operating state, the control circuit can further determine that the voltage at the inverter-side port is provided by a power grid via the turned-on bypass air switch. Therefore, the control circuit can accurately determine that the bypass air switch is in a turned-on state, and send an alarm signal. The detection method can effectively avoid false detection, and ensure high accuracy of detecting the turned-on state of the bypass air switch.

## Description

### TECHNICAL FIELD

This application relates to the field of power electronics technologies, and in particular, to a backup power system, and a method for detecting turn-on of a manual bypass circuit breaker.

### BACKGROUND

A backup power system usually includes an inverter and an on/off-grid controller. The on/off-grid controller is connected between the inverter and a power grid, and is configured to switch between an on-grid state and an off-grid state. The on/off-grid controller mainly includes an on/off-grid relay and a bypass circuit breaker. In the off-grid state, the on/off-grid relay is turned off, and the inverter converts a direct current supplied by a photovoltaic panel into an alternating current and then supplies power to a local load. In the on-grid state, the on/off-grid relay is turned on, the inverter converts a direct current supplied by a photovoltaic panel into an alternating current and then transmits the alternating current to the power grid via the on/off-grid relay, and in this case, a local load is powered by the inverter or the power grid. If the on/off-grid controller is faulty, the manual bypass circuit breaker can be manually turned on to short-circuit two ends of the on/off-grid controller, so that the power grid supplies power to the local load.

In the off-grid state, if the manual bypass circuit breaker is accidentally turned on, safety and stability of the backup power system are greatly affected. Therefore, a turned-on state of the manual bypass circuit breaker needs to be detected. Usually, the on/off-grid controller can detect a difference between voltages at two ends of the manual bypass circuit breaker to determine whether the manual bypass circuit breaker is turned on. However, the detection method may result in false detection and low accuracy.

### SUMMARY

This application provides a backup power system and a method for detecting turn-on of a manual bypass circuit breaker, to resolve a technical problem that detection accuracy is low when whether the manual bypass circuit breaker is turned on is detected based on a difference between voltages at two ends of the manual bypass circuit breaker.

According to a first aspect, a backup power system is provided. The backup power system includes an inverter and an on/off-grid controller. An inverter-side port of the on/off-grid controller is connected to the inverter, and a power grid-side port of the on/off-grid controller is configured to connect to a power grid. In addition, the on/off-grid controller includes an on/off-grid relay, a manual bypass circuit breaker, and a control circuit. The on/off-grid relay is connected between the inverter-side port and the power grid-side port, and the manual bypass circuit breaker is connected between the inverter-side port and the power grid-side port. The control circuit is separately connected to the inverter-side port, the power grid-side port, the inverter, and the on/off-grid relay. The inverter is configured to send a status indication signal to the control circuit, where the status indication signal indicates that the inverter is in an operating state or a non-operating state. The control circuit is configured to: detect a voltage at the inverter-side port and a voltage at the power grid-side port, and when the on/off-grid relay is turned off, if both the voltage at the inverter-side port and the voltage at the power grid-side port are greater than a first threshold, a difference between voltages at two ends of the manual bypass circuit breaker is less than a second threshold, and the inverter is in the non-operating state, send an alarm signal, where the alarm signal indicates that the manual bypass circuit breaker is in a turned-on state, and the first threshold is greater than the second threshold.

On a premise that the on/off-grid relay is turned off, if detecting that the difference between the voltages at the two ends of the manual bypass circuit breaker is less than the second threshold, the control circuit can determine that the voltage at the inverter-side port of the on/off-grid controller and the voltage at the power grid-side port are close. In this case, if the control circuit detects that the inverter is in the non-operating state, that is, the inverter does not output a voltage to the inverter-side port, and both the voltage at the inverter-side port and the voltage at the power grid-side port are greater than the first threshold, the control circuit can determine that the voltage at the inverter-side port is provided by the power grid via the turned-on manual bypass circuit breaker. Therefore, the control circuit can accurately determine that the manual bypass circuit breaker is in a turned-on state. The foregoing detection method can effectively avoid false detection, and ensure high accuracy of detecting the turned-on state of the manual bypass circuit breaker.

It may be understood that if the voltage at the inverter-side port or the voltage at the power grid-side port is less than the first threshold, that is, a voltage at any side port of the on/off-grid controller is low, the control circuit can determine that the manual bypass circuit breaker is not turned on. Alternatively, if the difference between the voltages at the two ends of the manual bypass circuit breaker is not less than the second threshold, that is, the voltage at the inverter-side port of the on/off-grid controller differs greatly from the voltage at the power grid-side port of the on/off-grid controller, the control circuit can also determine that the manual bypass circuit breaker is not turned on. If determining that the manual bypass circuit breaker is not turned on, the control circuit may stop the turn-on detection procedure, and the on/off-grid controller operates normally.

Optionally, the control circuit is configured to send the alarm signal if both the voltage at the inverter-side port and the voltage at the power grid-side port are greater than the first threshold, duration in which the difference between the voltages at the two ends of the manual bypass circuit breaker is less than the second threshold reaches first duration, and the inverter is in the non-operating state.

It may be understood that if the duration of a state in which the difference between the voltages at the two ends of the manual bypass circuit breaker remains to be less than the second threshold reaches the first duration, that is, the difference between the voltages at the two ends of the manual bypass circuit breaker constantly remains to be the state being less than the second threshold, the control circuit can more accurately determine that the manual bypass circuit breaker is in a turned-on state.

Optionally, the control circuit is further configured to: control, after determining that the manual bypass circuit breaker is turned on, the on/off-grid relay to remain in a turned-off state, and send a shutdown instruction to the inverter; and the inverter is further configured to shut down according to the shutdown instruction. After detecting that the manual bypass circuit breaker is turned on, the control circuit instructs, by using the shutdown instruction, the inverter to shut down. Safety of the backup power system can be effectively ensured. For example, a risk of human electric shock can be effectively reduced. That the control circuit controls the on/off-grid relay to remain in the turned-off state may also be considered as that the on/off-grid controller is in a shutdown state.

Optionally, the inverter-side port of the on/off-grid controller is further configured to connect to a backup load, and the power grid-side port of the on/off-grid controller is further configured to connect to a non-backup load. The backup load may be an important load in a household load, and the non-backup load may be an unimportant load in the household load. For example, the backup load may include a lighting device, and the non-backup load may include a smart home appliance. When a power grid side is powered off, the backup power system operates off-grid, the on/off-grid relay in the on/off-grid controller is turned off, and the inverter can supply power to the backup load, to ensure that the backup load can operate normally.

Optionally, the first threshold is k₁Uₙ, and the second threshold is k₂Uₙ; and *Uₙ* is a rated voltage of the power grid, k₁ is a first coefficient, and k₂ is a second coefficient. In addition, a value of the second coefficient ranges from 0.01 to 0.1, for example, may be 0.02. The first coefficient is greater than the second coefficient and less than 1, for example, may be 0.5.

According to a second aspect, another backup power system is provided. The backup power system includes an inverter and an on/off-grid controller. An inverter-side port of the on/off-grid controller is connected to the inverter, and a power grid-side port is configured to connect to a power grid. In addition, the on/off-grid controller includes an on/off-grid relay, a manual bypass circuit breaker, and a control circuit. The on/off-grid relay is connected between the inverter-side port and the power grid-side port, the manual bypass circuit breaker is connected between the inverter-side port and the power grid-side port, and the control circuit is separately connected to the inverter-side port, the power grid-side port, the inverter, and the on/off-grid relay. The inverter is configured to send a status indication signal to the control circuit, where the status indication signal indicates that the inverter is in an operating state or a non-operating state. The control circuit is configured to: detect a voltage at the inverter-side port and a voltage at the power grid-side port, and when the on/off-grid relay is turned off, if detecting that both the voltage at the inverter-side port and the voltage at the power grid-side port are greater than a first threshold and the inverter is in the operating state, send a disturbance instruction to the inverter. The inverter is configured to control, according to the disturbance instruction, effective voltages output by the inverter to be sequentially a first voltage and a second voltage, where the first voltage is different from the second voltage. That is, the inverter can control, according to the disturbance instruction, the effective voltages output by the inverter to be disturbed within a specific amplitude range, that is, output effective disturbance voltages. The control circuit is further configured to: detect a difference between voltages at two ends of the manual bypass circuit breaker after sending the disturbance instruction, and send an alarm signal if the difference between the voltages is less than a second threshold, where the alarm signal indicates that the manual bypass circuit breaker is in a turned-on state.

It may be understood that after the inverter outputs the effective disturbance voltages to the inverter-side port of the on/off-grid controller, voltages at the inverter-side port (namely, the effective voltages at the inverter-side port) fluctuate within a specific range. In this case, if detecting that the difference between the voltages at the two ends of the manual bypass circuit breaker is less than the second threshold, the control circuit can determine that the voltages at the power grid-side port can fluctuate, via the turned-on manual bypass circuit breaker, with fluctuation of the voltages at the inverter-side port. Therefore, the control circuit can accurately determine that the manual bypass circuit breaker is in the turned-on state, and send the alarm signal. The method for detecting turn-on can effectively avoid false detection, and ensure high accuracy of detecting the turned-on state of the manual bypass circuit breaker.

It may be further understood that after the inverter outputs the disturbance voltage to the inverter-side port of the on/off-grid controller, if the control circuit detects that the difference between the voltages at the two ends of the manual bypass circuit breaker is not less than the second threshold, that is, the voltage at the inverter-side port of the on/off-grid controller differs greatly from the voltage at the power grid-side port of the on/off-grid controller, the control circuit can determine that the manual bypass circuit breaker is not turned on. Then, the control circuit may stop the turn-on detection procedure, and the on/off-grid controller operates normally.

Optionally, the control circuit is configured to: when the on/off-grid relay is turned off, if detecting that both the voltage at the inverter-side port and the voltage at the power grid-side port are greater than the first threshold, the difference between the voltages at the two ends of the manual bypass circuit breaker is less than the second threshold, and the inverter is in the operating state, send the disturbance instruction to the inverter.

It may be understood that the control circuit may determine, when the on/off-grid relay is turned off, if detecting that both the voltage at the inverter-side port and the voltage at the power grid-side port are greater than the first threshold, and the difference between the voltages at the two ends of the manual bypass circuit breaker is less than the second threshold, that the manual bypass circuit breaker may be in the turned-on state. Therefore, the control circuit may continue to perform a subsequent turn-on detection procedure, that is, send the disturbance instruction to the inverter.

Optionally, the control circuit is configured to: when the on/off-grid relay is turned off, if detecting that both the voltage at the inverter-side port and the voltage at the power grid-side port are greater than the first threshold, duration in which the difference between the voltages at the two ends of the manual bypass circuit breaker is less than the second threshold reaches first duration, and the inverter is in the operating state, send the disturbance instruction to the inverter.

Optionally, the control circuit is configured to send, within second duration after sending the disturbance instruction, the alarm signal if detecting that duration in which the difference between the voltages at the two ends of the manual bypass circuit breaker is less than the second threshold reaches third duration; and the second duration is greater than the third duration.

That is, the control circuit can continuously detect the difference between the voltages at the two ends of the manual bypass circuit breaker within a detection time window after sending the disturbance instruction, and duration of the detection time window is the second duration. If, within the detection time window, the duration of a state in which the difference between the voltages at the two ends of the manual bypass circuit breaker remains to be less than the second threshold reaches the third duration, the control circuit can accurately determine that the manual bypass circuit breaker is in the turned-on state, and send the alarm signal.

Optionally, duration of the first voltage is fourth duration, and duration of the second voltage is fifth duration; and the third duration is greater than the fourth duration and greater than the fifth duration.

After receiving the disturbance instruction, the inverter can control the effective voltage output by the inverter to remain the first voltage within the fourth duration, and control the effective voltage output by the inverter to remain the second voltage within the fifth duration. Therefore, it can be learned that the effective voltages output by the inverter at least fluctuate only within a duration range greater than the fourth duration or greater than the fifth duration. Correspondingly, if detecting that the difference between the voltages at the two ends of the manual bypass circuit breaker is less than the second threshold within the third duration (namely, within a duration range greater than the fourth duration and greater than the fifth duration), the control circuit can accurately determine that the manual bypass circuit breaker is in the turned-on state.

Optionally, the first voltage is (1 + *k*₃)*Uₙ,* the second voltage is (1 - *k*₃)*Uₙ,* and *Uₙ* is a rated voltage of the power grid, and k₃ is a third coefficient whose value ranges from 0 to 0.2. For example, the third coefficient may be 0.05.

Optionally, the control circuit is further configured to: control, after determining that the manual bypass circuit breaker is turned on, the on/off-grid relay to remain in a turned-off state, and send a shutdown instruction to the inverter; and the inverter is further configured to shut down according to the shutdown instruction.

Optionally, the inverter-side port of the on/off-grid controller is further configured to connect to a backup load, and the power grid-side port of the on/off-grid controller is further configured to connect to a non-backup load.

According to a third aspect, a method for detecting turn-on of a manual bypass circuit breaker is provided and applied to the backup power system provided in the first aspect. The method includes: detecting a voltage at an inverter-side port of an on/off-grid controller, a voltage at a power grid-side port, and an operating status of an inverter; and when an on/off-grid relay is turned off, if both the voltage at the inverter-side port and the voltage at the power grid-side port are greater than a first threshold, a difference between voltages at two ends of the manual bypass circuit breaker is less than a second threshold, and the inverter is in a non-operating state, sending an alarm signal, where the alarm signal indicates that the manual bypass circuit breaker is in a turned-on state.

According to a fourth aspect, another method for detecting turn-on of a manual bypass circuit breaker is provided and applied to the backup power system provided in the second aspect. The method includes: detecting a voltage at an inverter-side port of an on/off-grid controller, a voltage at a power grid-side port, and an operating status of an inverter; when an on/off-grid relay is turned off, if detecting that both the voltage at the inverter-side port and the voltage at the power grid-side port are greater than a first threshold and the inverter is in an operating state, sending a disturbance instruction to the inverter; controlling, by the inverter according to the disturbance instruction, effective voltages output by the inverter to be sequentially a first voltage and a second voltage, where the first voltage is different from the second voltage; and sending an alarm signal if detecting that a difference between voltages at two ends of the manual bypass circuit breaker is less than a second threshold after sending the disturbance instruction, where the alarm signal indicates that the manual bypass circuit breaker is in a turned-on state.

According to a fifth aspect, an on/off-grid controller is provided. An inverter-side port of the on/off-grid controller is configured to connect to an inverter, and a power grid-side port is configured to connect to a power grid. In addition, the on/off-grid controller includes an on/off-grid relay, a manual bypass circuit breaker, and a control circuit. The on/off-grid relay is connected between the inverter-side port and the power grid-side port, and the manual bypass circuit breaker is connected between the inverter-side port and the power grid-side port. The control circuit is separately connected to the inverter-side port, the power grid-side port, the inverter, and the on/off-grid relay. The control circuit is configured to: detect a voltage at the inverter-side port, a voltage at the power grid-side port, and an operating status of the inverter, and when the on/off-grid relay is turned off, if both the voltage at the inverter-side port and the voltage at the power grid-side port are greater than a first threshold, a difference between voltages at two ends of the manual bypass circuit breaker is less than a second threshold, and an inverter is in a non-operating state, send an alarm signal, where the alarm signal indicates that the manual bypass circuit breaker is in a turned-on state.

According to a sixth aspect, another on/off-grid controller is provided. An inverter-side port of the on/off-grid controller is connected to the inverter, and a power grid-side port is configured to connect to a power grid. In addition, the on/off-grid controller includes an on/off-grid relay, a manual bypass circuit breaker, and a control circuit. The on/off-grid relay is connected between the inverter-side port and the power grid-side port, and the manual bypass circuit breaker is connected between the inverter-side port and the power grid-side port. The control circuit is separately connected to the inverter-side port, the power grid-side port, the inverter, and the on/off-grid relay. The control circuit is configured to: detect a voltage at the inverter-side port, a voltage at the power grid-side port, and an operating status of the inverter; and when the on/off-grid relay is turned off, if detecting that both the voltage at the inverter-side port and the voltage at the power grid-side port are greater than a first threshold and an inverter is in an operating state, send a disturbance instruction to the inverter. The inverter is configured to control, according to the disturbance instruction, effective voltages output by the inverter to be sequentially a first voltage and a second voltage, where the first voltage is different from the second voltage. The control circuit is further configured to: detect a difference between voltages at two ends of the manual bypass circuit breaker after sending the disturbance instruction, and send an alarm signal if the difference between the voltages is less than a second threshold, where the alarm signal indicates that the manual bypass circuit breaker is in a turned-on state.

In conclusion, this application provides the backup power system and the method for detecting turn-on of the manual bypass circuit breaker. The control circuit in the on/off-grid controller can detect the voltage at the inverter-side port of the on/off-grid controller, the voltage at the power grid-side port, and the operating status of the inverter. On the premise that the on/off-grid relay is turned off, if detecting that the difference between the voltages at the two ends of the manual bypass circuit breaker is less than the second threshold, the control circuit can determine that the voltage at the inverter-side port of the on/off-grid controller and the voltage at the power grid-side port are close. In this case, if the control circuit detects that the inverter is in the non-operating state, that is, the inverter does not output a voltage to the inverter-side port, and both the voltage at the inverter-side port and the voltage at the power grid-side port are greater than the first threshold, the control circuit can determine that the voltage at the inverter-side port is provided by the power grid via the turned-on manual bypass circuit breaker. Therefore, the control circuit can accurately determine that the manual bypass circuit breaker is in the turned-on state, and send the alarm signal. Because the control circuit can determine, based on the operating status of the inverter and the difference between the voltages at the two ends of the manual bypass circuit breaker, whether the manual bypass circuit breaker is turned on, this can effectively avoid false detection, and ensure high accuracy of detecting the turned-on state of the manual bypass circuit breaker.

### BRIEF DESCRIPTION OF DRAWINGS

FIG. 1 is a diagram of a structure of a backup power system according to an embodiment of this application;
FIG. 2 is a diagram of a structure of another backup power system according to an embodiment of this application;
FIG. 3 is a diagram of a structure of an on/off-grid controller according to an embodiment of this application; and
FIG. 4A and FIG. 4B are a flowchart of a method for detecting turn-on of a manual bypass circuit breaker according to an embodiment of this application.

### DESCRIPTION OF EMBODIMENTS

With reference to the accompanying drawings, the following describes in detail a backup power system and a method for detecting turn-on of a manual bypass circuit breaker that are provided in embodiments of this application. Key terms in embodiments of this application are first described.

An inverter (inverter, INV), also referred to as a power converter, is configured to: convert a direct current (direct current, DC) output by a photovoltaic panel (also referred to as a solar panel) or an energy storage battery into an alternating current (alternating current, AC), and transmit the alternating current to a power grid, or supply power to a load connected to an electric power system.

An on/off-grid controller, also referred to as an on/off-grid control box or back-up box (back-up box), is connected between an inverter and a power grid, and is configured to switch between on-grid and off-grid based on voltage statuses of a power grid side and an inverter side.

On-grid (On-grid) indicates an operating state in which an inverter converts a direct current generated by a photovoltaic panel into an alternating current and then transmits the alternating current to a power grid. In an on-grid state, a load is powered by the power grid or the inverter.

Off-grid (Off-grid) indicates a state of independent operating without depending on a power grid. In an off-grid state, an inverter can convert a direct current provided by a photovoltaic panel or an energy storage battery into an alternating current and then supply power to a load.

A backup load is an important load that needs to be powered by an inverter in cooperation with a photovoltaic panel or an energy storage battery when a power grid side is powered off. For example, the backup load may include a lighting device in a household load.

A non-backup load is an unimportant load that does not need to be powered when a power grid side is powered off, to ensure that a backup load can be powered for a long time. For example, the non-backup load may include a smart home appliance in a household load.

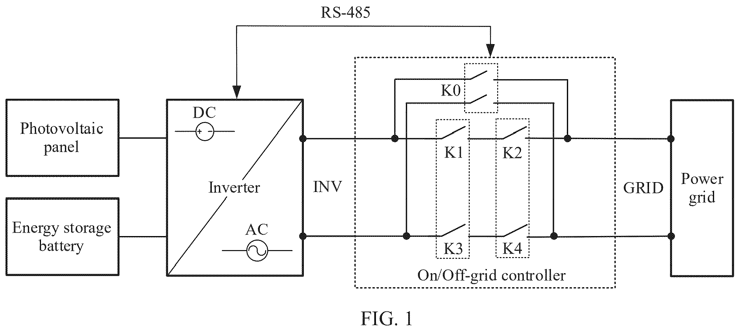

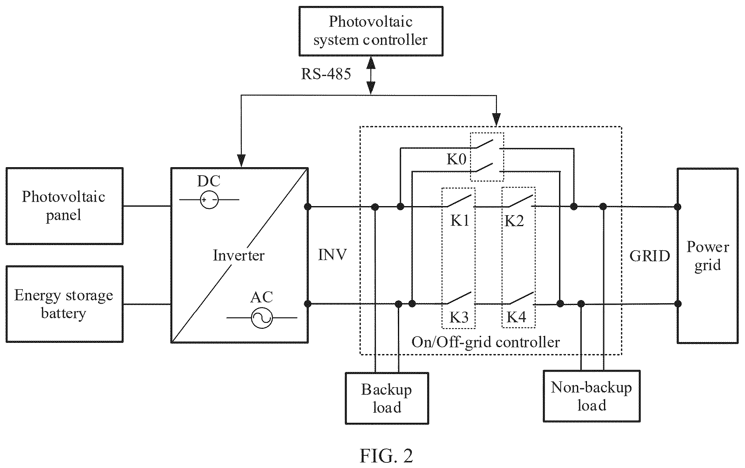

FIG. 1 is a diagram of a structure of a backup power system (also referred to as a whole-house backup power system) according to an embodiment of this application. As shown in FIG. 1, the backup power system includes an inverter and an on/off-grid controller. A direct current end of the inverter is connected to a direct current power supply, and the direct current power supply may include a photovoltaic panel. Alternatively, refer to FIG. 1. The direct current power supply includes a photovoltaic panel and an energy storage battery. An alternating current end of the inverter is connected to an inverter-side INV port of the on/off-grid controller, and a power grid-side GRID port of the on/off-grid controller is configured to connect to a power grid. As shown in FIG. 2, the inverter-side INV port of the on/off-grid controller is further configured to connect to a backup load, and the power grid-side GRID port of the on/off-grid controller is further configured to connect to a non-backup load.

The on/off-grid controller usually includes an on/off-grid relay and a manual bypass circuit breaker K0. The manual bypass circuit breaker K0 is also referred to as a bypass air switch, a bypass circuit breaker, or a bypass relay. The manual bypass circuit breaker K0 can be manually controlled by a user to be turned on or turned off. In addition, the manual bypass circuit breaker K0 further has an overcurrent protection function. To be specific, the manual bypass circuit breaker K0 can be automatically turned off when a current flowing through the manual bypass circuit breaker K0 is greater than a specific threshold.

To meet a safety requirement, as shown in FIG. 1 and FIG. 2, the on/off-grid relay usually includes inverter-side relays (K1 and K3) and power grid-side relays (K2 and K4). The manual bypass circuit breaker K0 is connected in parallel to two ends of the inverter-side relays (K1 and K3) and two ends of the power grid-side relays (K2 and K4). Each relay is in a turned-off state by default, and is configured to disconnect the inverter from the power grid. Correspondingly, in this case, the backup power system operates off-grid, and the inverter converts a direct current supplied by the direct current power supply into an alternating current, and then supplies power to the backup load. When all of the inverter-side relays (K1 and K3) and the power grid-side relays (K2 and K4) are turned on, the backup power system operates on-grid. In this case, the inverter can transmit the alternating current to the power grid via the on/off-grid controller. In addition, in this case, the backup load and the non-backup load are powered by the inverter or the power grid.

When an internal hardware circuit of the on/off-grid controller is faulty, the user may manually turn on the manual bypass circuit breaker K0 to directly short-circuit the inverter-side relays (K1 and K3) and the power grid-side relays (K2 and K4), to transmit mains supply from the power grid to the backup load, thereby supplying power to the backup load.

However, when the on/off-grid controller is not faulty and the backup power system operates off-grid, that is, when all of the inverter-side relays (K1 and K3) and the power grid-side relays (K2 and K4) are turned off, if the manual bypass circuit breaker K0 is accidentally turned on or is turned on due to a component fault, safety and stability of the backup power system are affected. For example, when the user powers off the power grid side for maintenance or another operation, if the manual bypass circuit breaker K0 is turned on, an output voltage of the inverter in an off-grid state is directly output to the power grid-side GRID port via the turned-on manual bypass circuit breaker K0, and there is a risk of human electric shock.

Alternatively, when the power grid-side GRID port does not have power, if the manual bypass circuit breaker K0 is turned on, the on/off-grid controller detects that there is a voltage at the power grid-side GRID port, and considers that the power grid is normal. In this case, the on/off-grid controller performs an operation of switching off-grid to on-grid, that is, the on/off-grid controller turns on the inverter-side relays (K1 and K3) and the power grid-side relays (K2 and K4). However, the power grid actually has no voltage and cannot maintain on-grid. As a result, the on/off-grid controller repeatedly switches between on-grid and off-grid, affecting system stability.

Based on the foregoing analysis, to ensure safety and stability of the backup power system, when all of the inverter-side relays (K1 and K3) and the power grid-side relays (K2 and K4) are in the turned-off state, the on/off-grid controller needs to accurately detect whether the manual bypass circuit breaker K0 is turned on. When detecting that the manual bypass circuit breaker K0 is turned on, the on/off-grid controller may send an alarm signal to indicate the user to turn off the manual bypass circuit breaker K0. Usually, the on/off-grid controller may directly detect a difference between voltages at two ends of the manual bypass circuit breaker K0, and determine, based on a value of the difference between the voltages, whether the manual bypass circuit breaker K0 is turned on, for example, determine, if the difference between the voltages is less than a threshold, that the manual bypass circuit breaker K0 is turned on. However, the detection method has a probability of false detection, and low detection accuracy.

For example, when all of the inverter-side relays (K1 and K3) and the power grid-side relays (K2 and K4) are in the turned-off state, and the manual bypass circuit breaker K0 is also turned off, if both the alternating current end of the inverter and the power grid side have power, when the difference between the voltages at the two ends of the manual bypass circuit breaker K0 is detected, if a voltage at the alternating current end of the inverter and a voltage at the power grid side have a same amplitude and a same phase, the detected difference between voltage is small. As a result, it is falsely determined that the manual bypass circuit breaker K0 is turned on.

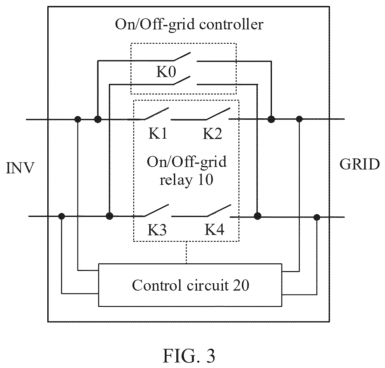

An embodiment of this application provides an on/off-grid controller. The on/off-grid controller is used in an application scenario shown in FIG. 1 or FIG. 2, and can accurately detect whether a manual bypass circuit breaker K0 is turned on. As shown in FIG. 3, the on/off-grid controller has an inverter-side INV port and a power grid-side GRID port. The inverter-side INV port is configured to connect to an inverter, and the power grid-side GRID port is configured to connect to a power grid. In addition, the on/off-grid controller includes an on/off-grid relay 10, the manual bypass circuit breaker K0, and a control circuit 20.

The on/off-grid relay 10 is connected between the inverter-side INV port and the power grid-side GRID port, and the manual bypass circuit breaker K0 is also connected between the inverter-side INV port and the power grid-side GRID port. An on/off state of the on/off-grid relay 10 is controlled by the control circuit 20. An on/off state of the manual bypass circuit breaker K0 may be manually controlled, and when the manual bypass circuit breaker K0 is in a turned-on state, if it is detected that a current flowing through the manual bypass circuit breaker K0 is greater than a specific threshold, the manual bypass circuit breaker K0 may alternatively be automatically turned off. In addition, when the manual bypass circuit breaker K0 is turned on, the on/off-grid relay 10 may be short-circuited.

The control circuit 20 is separately connected to the inverter-side INV port, the power grid-side GRID port, the inverter, and the on/off-grid relay. The control circuit 20 is configured to: detect a voltage at the inverter-side INV port, a voltage at the power grid-side GRID port, and an operating status of the inverter; and when the on/off-grid relay 10 is turned off, if both the voltage at the inverter-side INV port and the voltage at the power grid-side GRID port are greater than a first threshold, a difference between voltages at two ends of the manual bypass circuit breaker K0 is less than a second threshold, and the inverter is in a non-operating state, send an alarm signal, where the alarm signal indicates that the manual bypass circuit breaker K0 is in a turned-on state.

The difference between the voltages at the two ends of the manual bypass circuit breaker K0 is equal to a difference between the voltage at the inverter-side INV port and the voltage at the power grid-side GRID port. In other words, the control circuit 20 may obtain, through calculation, the difference between the voltages at the two ends of the manual bypass circuit breaker K0 by performing difference calculation on the voltage at the inverter-side INV port and the voltage at the power grid-side GRID port.

It may be understood that the first threshold is greater than the second threshold. The first threshold may be preconfigured in the control circuit 20, and the first threshold may be set based on a rated voltage Uₙ of the power grid. For example, the first threshold may be k₁Uₙ, k₁ is a first coefficient, and the first coefficient k₁ may be greater than 0 and less than 1. For example, the first coefficient k₁ may be 0.5. It may be further understood that the second threshold may be a small voltage value preconfigured in the control circuit 20. If the difference between the voltages at the two ends of the manual bypass circuit breaker K0 is less than the second threshold, it indicates that the voltage at the inverter-side INV port and the voltage at the power grid-side GRID port are close. The second threshold may also be set based on the rated voltage Uₙ of the power grid. For example, the second threshold may be k₂Uₙ, k₂ is a second coefficient, and a value of the second coefficient k₂ may be greater than 0 and less than the first coefficient k₁. For example, a value of the coefficient k₂ may range from 0.01 to 0.1, for example, may be 0.02.

It may be further understood that the inverter may send a status indication signal to the control circuit 20 in the on/off-grid controller. The status indication signal indicates that the inverter is in an operating state or the non-operating state. The non-operating state may be a state in which the inverter does not perform power conversion, namely, a state in which the inverter does not output power. The operating state may be a state in which the inverter performs power conversion and outputs power. For example, the operating state of the inverter may include an off-grid operating state, an on-grid operating state, and the like. The non-operating state of the inverter may include a startup state, a shutdown state, and the like.

Optionally, the status indication signal sent by the inverter may include a flag bit. Different values of the flag bit may indicate that the inverter is in different states. For example, a value 1 of the flag bit may indicate that the inverter is in the operating state. A value 0 of the flag bit may indicate that the inverter is in the non-operating state.

As described above, when the inverter is in the non-operating state, the inverter does not output power at the inverter-side INV port of the on/off-grid controller, that is, does not output a voltage. Based on this, if the on/off-grid relay 10 is turned off, the difference between the voltages at the two ends of the manual bypass circuit breaker K0 is small, that is, the voltage at the inverter-side INV port and the voltage at the power grid-side GRID port are close, and both the voltage at the inverter-side INV port and the voltage at the power grid-side GRID port are greater than the first threshold, the control circuit 20 can determine that the voltage at the inverter-side INV port is provided by the power grid via the turned-on manual bypass circuit breaker K0. Therefore, the control circuit 20 can accurately determine that the manual bypass circuit breaker K0 is in the turned-on state, and send the alarm signal. In addition, it can be learned from the foregoing analysis that the solution provided in this embodiment of this application can be used to accurately detect, in a scenario in which the power grid has power and the inverter is in the non-operating state, whether the manual bypass circuit breaker K0 is turned on.

Optionally, the alarm signal may include a sound alarm signal and/or a light alarm signal. A user may turn off the manual bypass circuit breaker K0 in time based on the alarm signal.

Optionally, after determining that the manual bypass circuit breaker K0 is in the turned-on state, the control circuit 20 may further control the on/off-grid relay 10 to remain in a turned-off state. In addition, the control circuit 20 may send a shutdown instruction to the inverter. The shutdown instruction may instruct the inverter to shut down. Shutting down the inverter may mean that the inverter stops performing power conversion. That the control circuit 20 controls the on/off-grid relay 10 to remain in the turned-off state may alternatively be considered as controlling the on/off-grid controller to shut down. This can not only effectively reduce a safety risk, but also avoid affecting system stability because the on/off-grid controller repeatedly switches between on-grid and off-grid.

Optionally, refer to FIG. 1. The inverter and the on/off-grid controller may establish a communication connection through an RS-485 bus. Correspondingly, the inverter may send the status indication signal to the control circuit 20 in the on/off-grid controller through the RS-485 bus. In addition, the control circuit 20 may send the shutdown instruction to the inverter through the RS-485 bus.

Alternatively, refer to FIG. 2. The backup power system further includes a photovoltaic system controller. The inverter and the on/off-grid controller may establish the communication connection through an RS-485 bus and the photovoltaic system controller. Correspondingly, the inverter may send the status indication signal to the control circuit 20 in the on/off-grid controller through the RS-485 bus and the photovoltaic system controller. In addition, the control circuit 20 may send the shutdown instruction to the inverter through the RS-485 bus and the photovoltaic system controller. For example, the inverter may send the status indication signal to the photovoltaic system controller through the RS-485 bus, and further the photovoltaic system controller may forward the status indication signal to the control circuit 20 in the on/off-grid controller through the RS-485 bus. The control circuit 20 may send the shutdown instruction to the photovoltaic system controller through the RS-485 bus, and further the photovoltaic system controller may forward the shutdown instruction to the inverter through the RS-485 bus.

Optionally, the control circuit 20 may be configured to send the alarm signal if both the voltage at the inverter-side INV port and the voltage at the power grid-side GRID port are greater than the first threshold, and duration in which the difference between the voltages at the two ends of the manual bypass circuit breaker K0 is less than the second threshold reaches first duration, and the inverter is in the non-operating state. The first duration t1 is also pre-stored in the control circuit 20. For example, a value of the first duration t1 may range from 2 seconds to 5 seconds, for example, the first duration t1 may be 3 seconds.

It may be understood that if the duration of a state in which the difference between the voltages at the two ends of the manual bypass circuit breaker K0 remains to be less than the second threshold reaches the first duration, that is, the difference between the voltages at the two ends of the manual bypass circuit breaker K0 constantly remains to be the state being less than the second threshold, the control circuit 20 can more accurately determine that the manual bypass circuit breaker K0 is in the turned-on state. This can ensure accuracy of turn-on detection.

Optionally, in this embodiment of this application, after being powered on, the control circuit 20 may first perform system initialization. The on/off-grid relay 10 is turned off during system initialization. Then, the control circuit 20 may first detect the voltage at the inverter-side INV port and the voltage at the power grid-side GRID port. If the voltage at the inverter-side INV port or the voltage at the power grid-side GRID port is not greater than the first threshold, that is, the voltage at any side port of the on/off-grid controller is low, the control circuit 20 may determine that the manual bypass circuit breaker K0 is in a turned-off state. Further, the control circuit 20 does not need to perform a subsequent turn-on detection procedure, and the backup power system may continue to operate normally. If both the voltages at the two ports are greater than the first threshold, the control circuit 20 may continue to detect the difference between the voltages at the two ends of the manual bypass circuit breaker K0. If the difference between the voltages at the two ends of the manual bypass circuit breaker K0 is greater than or equal to the second threshold, the control circuit 20 may determine that the manual bypass circuit breaker K0 is not turned on, and stop a subsequent turn-on detection procedure, and the backup power system may continue to operate normally. If the difference between the voltages at the two ends of the manual bypass circuit breaker K0 is less than the second threshold, the control circuit 20 may continue to detect whether the inverter is in the operating state. If the inverter is in the non-operating state, the control circuit 20 may determine that the manual bypass circuit breaker K0 is in the turned-on state, and send the alarm signal.

It may be understood that the control circuit 20 may alternatively first detect the operating status of the inverter, and then detect the voltage at the inverter-side INV port and the voltage at the power grid-side GRID port. A sequence of detecting the foregoing states is not limited in this embodiment of this application.

It may be further understood that if the control circuit 20 detects that neither the voltage at the inverter-side INV port nor the voltage at the power grid-side GRID port is greater than the first threshold, that is, detects that neither the inverter-side INV port nor the power grid-side GRID port has power, no impact is caused on safety and system stability even if the manual bypass circuit breaker K0 is turned on in this case. Therefore, the control circuit 20 may not perform a subsequent turn-on detection procedure.

In conclusion, this embodiment of this application provides the on/off-grid controller. The control circuit in the on/off-grid controller can detect the difference between the voltages at the two ends of the manual bypass circuit breaker and the operating status of the inverter. On a premise that the on/off-grid relay is turned off, if detecting that the difference between the voltages at the two ends of the manual bypass circuit breaker is less than the second threshold, the control circuit can determine that the voltage at the inverter-side port of the on/off-grid controller and the voltage at the power grid-side port are close. In this case, if the control circuit detects that the inverter is in the non-operating state, that is, the inverter does not output a voltage to the inverter-side port, and both the voltage at the inverter-side port and the voltage at the power grid-side port are greater than the first threshold, the control circuit can determine that the voltage at the inverter-side port is provided by the power grid via the turned-on manual bypass circuit breaker. Therefore, the control circuit can accurately determine that the manual bypass circuit breaker is in the turned-on state, and send the alarm signal. Because the control circuit can determine, based on the operating status of the inverter and the difference between the voltages at the two ends of the manual bypass circuit breaker, whether the manual bypass circuit breaker is turned on, this can effectively avoid false detection, and ensure high accuracy of detecting the turned-on state of the manual bypass circuit breaker.

In addition, in the foregoing detection process, there is no need to control the on/off state of a detected relay (namely, the manual bypass circuit breaker), that is, no manual intervention is required. For a manual bypass circuit breaker that cannot be automatically controlled to be turned on or turned off through drive, a turned-on state of the manual bypass circuit breaker can be accurately detected.

An embodiment of this application provides another on/off-grid controller. The on/off-grid controller is used in the application scenario shown in FIG. 1 or FIG. 2, and can accurately detect whether a manual bypass circuit breaker K0 is turned on. As shown in FIG. 3, the on/off-grid controller has an inverter-side INV port and a power grid-side GRID port. The inverter-side INV port is configured to connect to an inverter, and the power grid-side GRID port is configured to connect to a power grid. In addition, the on/off-grid controller includes an on/off-grid relay 10, the manual bypass circuit breaker K0, and a control circuit 20.

The control circuit 20 is separately connected to the inverter-side INV port, the power grid-side GRID port, the inverter, and the on/off-grid relay. The control circuit 20 is configured to: detect a voltage at the inverter-side INV port, a voltage at the power grid-side GRID port, and an operating status of the inverter; and when the on/off-grid relay 10 is turned off, if detecting that both the voltage at the inverter-side INV port and the voltage at the power grid-side GRID port are greater than a first threshold and the inverter is in an operating state, send a disturbance instruction to the inverter. The disturbance instruction instructs the inverter to control effective voltages output by the inverter to be sequentially a first voltage and a second voltage, where the first voltage is different from the second voltage. That is, the inverter can output, according to the disturbance instruction, to the inverter-side INV port of the on/off-grid controller, effective voltages that are disturbed within a specific amplitude range, that is, output disturbance voltages to the inverter-side INV port of the on/off-grid controller.

The control circuit 20 is further configured to: detect a difference between voltages at two ends of the manual bypass circuit breaker K0 after sending the disturbance instruction, and send an alarm signal if detecting that the difference between the voltages is less than a second threshold, where the alarm signal indicates that the manual bypass circuit breaker K0 is in a turned-on state. The difference between the voltages at the two ends of the manual bypass circuit breaker K0 is equal to a difference between the voltage at the inverter-side INV port and the voltage at the power grid-side GRID port.

For explanations of the first threshold, the second threshold, and the operating status of the inverter, refer to related descriptions in the foregoing embodiment. For an implementation of the alarm signal, refer to related descriptions in the foregoing embodiment. Details are not described herein again.

It may be understood that, that the difference between the voltages at the two ends of the manual bypass circuit breaker K0 is less than the second threshold indicates that the voltage at the inverter-side INV port of the on/off-grid controller and the voltage at the power grid-side GRID port are close to each other. In this embodiment of this application, on a premise that the on/off-grid relay 10 is turned off, after the inverter outputs the effective disturbance voltages to the inverter-side INV port, voltages at the inverter-side INV port (namely, the effective voltages at the inverter-side INV port) fluctuate within a specific range. In this case, if the control circuit 20 detects that the difference between the voltages at the two ends of the manual bypass circuit breaker K0 is less than the second threshold, it indicates that the power grid does not have power, and the voltages at the power grid-side GRID port can fluctuate, via the turned-on manual bypass circuit breaker K0, with fluctuation of the voltages at the inverter-side INV port. Therefore, the control circuit 20 can accurately determine that the manual bypass circuit breaker K0 is in the turned-on state, and send the alarm signal. The method for detecting turn-on can effectively avoid false detection, and ensure high accuracy of detecting the turned-on state of the manual bypass circuit breaker.

It can be learned from the foregoing analysis that the solution provided in this embodiment of this application can be used to accurately detect, in a scenario in which the inverter is in the operating state and the power grid does not have power, whether the manual bypass circuit breaker K0 is turned on.

It may be further understood that if the inverter is in the operating state and the power grid has power, when both the manual bypass circuit breaker K0 and the on/off-grid relay 10 are turned off, the inverter can normally operate off-grid. If the inverter is in the operating state and the power grid has power, when the manual bypass circuit breaker K0 is turned on, the inverter may detect an alarm and shut down, that is, the inverter enters a non-operating state. In this case, the on/off-grid controller may detect, by using the solution provided in the foregoing embodiment, that the manual bypass circuit breaker K0 is in the turned-on state.

Optionally, after determining that the manual bypass circuit breaker K0 is in the turned-on state, the control circuit 20 may further control the on/off-grid relay 10 to remain in a turned-off state. In addition, the control circuit 20 may send a shutdown instruction to the inverter. The shutdown instruction may instruct the inverter to shut down. Shutting down the inverter may mean that the inverter stops performing power conversion. That the control circuit 20 controls the on/off-grid relay 10 to remain in the turned-off state may alternatively be considered as controlling the on/off-grid controller to shut down.

Optionally, the control circuit 20 is configured to: when the on/off-grid relay 10 is turned off, if detecting that both the voltage at the inverter-side INV port and the voltage at the power grid-side GRID port are greater than the first threshold, the difference between the voltages at the two ends of the manual bypass circuit breaker K0 is less than the second threshold, and the inverter is in the operating state, send the disturbance instruction to the inverter.

It may be understood that the control circuit 20 may determine, when the on/off-grid relay 10 is turned off, if detecting that both the voltage at the inverter-side INV port and the voltage at the power grid-side GRID port are greater than the first threshold and the difference between the voltages at the two ends of the manual bypass circuit breaker K0 is less than the second threshold, that the manual bypass circuit breaker K0 may be in the turned-on state. Therefore, the control circuit 20 may continue to perform a subsequent turn-on detection procedure, that is, send the disturbance instruction to the inverter based on the inverter being in the operating state.

It may be further understood that if the voltage at the inverter-side INV port of the on/off-grid controller or the voltage at the power grid-side GRID port is not greater than the first threshold, that is, the voltage at any side port of the on/off-grid controller is low, the control circuit 20 may determine that the manual bypass circuit breaker K0 is in a turned-off state. Further, the control circuit 20 does not need to perform a subsequent turn-on detection procedure, and the backup power system may continue to operate normally. If both the voltage at the inverter-side INV port of the on/off-grid controller and the voltage at the power grid-side GRID port are greater than the first threshold, the control circuit 20 may determine that the manual bypass circuit breaker K0 may be in the turned-on state, and may continue to perform a subsequent turn-on detection procedure, for example, continue to detect whether the difference between the voltages at the two ends of the manual bypass circuit breaker K0 is less than the second threshold. This can ensure accuracy of subsequent turn-on detection.

Further, if the control circuit 20 detects that the difference between the voltages at the two ends of the manual bypass circuit breaker K0 is not less than the second threshold, that is, the voltage at the inverter-side INV port of the on/off-grid controller differs greatly from the voltage at the power grid-side GRID port, the control circuit 20 may determine that the manual bypass circuit breaker K0 is not turned on. Correspondingly, the control circuit 20 may stop the turn-on detection procedure, and the backup power system may continue to operate normally.

Optionally, the control circuit 20 is configured to: when the on/off-grid relay 10 is turned off, if detecting that both the voltage at the inverter-side INV port and the voltage at the power grid-side GRID port are greater than the first threshold, duration in which the difference between the voltages at the two ends of the manual bypass circuit breaker K0 is less than the second threshold reaches first duration, and the inverter is in the operating state, send the disturbance instruction to the inverter.

The first duration t1 may be pre-stored in the control circuit 20. For example, a value of the first duration t1 may range from 2 seconds to 5 seconds, for example, the first duration t1 may be 3 seconds. It may be understood that if the duration of a state in which the difference between the voltages at the two ends of the manual bypass circuit breaker K0 remains to be less than the second threshold reaches the first duration, the control circuit 20 may determine that there is a high probability that the manual bypass circuit breaker K0 is in the turned-on state. Therefore, the control circuit 20 may send the disturbance instruction to the inverter, to further verify whether the manual bypass circuit breaker K0 is in the turned-on state.

Optionally, the control circuit 20 is configured to send, within second duration after sending the disturbance instruction, the alarm signal if detecting that duration in which the difference between the voltages at the two ends of the manual bypass circuit breaker K0 is less than the second threshold reaches third duration. That is, the control circuit 20 can continuously detect the difference between the voltages at the two ends of the manual bypass circuit breaker K0 within a detection time window after sending the disturbance instruction, and duration of the detection time window is the second duration. If, within the detection time window, the duration of a state in which the difference between the voltages at the two ends of the manual bypass circuit breaker K0 remains to be less than the second threshold reaches the third duration, the control circuit 20 can accurately determine that the manual bypass circuit breaker K0 is in the turned-on state, and send the alarm signal.

The second duration t2 and the third duration t3 may be fixed values preconfigured in the control circuit 20, and the second duration t2 is greater than the third duration t3. For example, the second duration t2 may be 10 seconds, and the third duration t3 may be 6 seconds.

Optionally, the disturbance instruction sent by the control circuit 20 may indicate that duration of the first voltage output by the inverter is fourth duration, and duration of the second voltage is fifth duration, where the third duration is greater than the fourth duration and greater than the fifth duration.

It may be understood that both the first voltage and the second voltage may be set based on a rated voltage Uₙ of the power grid. For example, the first voltage may be (1 *+ k*₃)*Uₙ,* and the second voltage may be (1 - *k*₃)*Uₙ.* Alternatively, the first voltage may be (1 - *k*₃)*Uₙ,* and the second voltage may be (1 + *k*₃)*Uₙ.* k₃ is a third coefficient, and the third coefficient k₃ may be a number greater than 0 and less than or equal to 0.2. For example, the third coefficient k₃ may be 0.05 or 0.1. In other words, the inverter may control, according to the disturbance instruction, the output voltages at the alternating current end of the inverter to fluctuate within a small range.

It may be further understood that the fourth duration t4 and the fifth duration t5 may be equal or may be unequal. This is not limited in this embodiment of this application. In addition, the third duration t3 needs to be greater than the fourth duration t4 and greater than the fifth duration t5, to ensure detection accuracy. Optionally, the third duration t3 may be greater than or equal to a sum of the fourth duration t4 and the fifth duration t5. For example, both the fourth duration t4 and the fifth duration t5 may be 3 seconds. A value of the third duration t3 may range from 5 seconds to 10 seconds, for example, the third duration t3 may be 6 seconds.

After receiving the disturbance instruction, the inverter can control the effective voltage output by the inverter to remain the first voltage within the fourth duration t4, and control the effective voltage output by the inverter to remain the second voltage within the fifth duration t5. Therefore, it can be learned that the effective voltages of voltages output by the inverter at least fluctuate only within a duration range greater than the fourth duration t4 or greater than the fifth duration t5. Correspondingly, if detecting that the difference between the voltages at the two ends of the manual bypass circuit breaker K0 is less than the second threshold within the third duration t3 (namely, within a duration range greater than the fourth duration t4 and greater than the fifth duration t5), the control circuit 20 can accurately determine that the manual bypass circuit breaker K0 is in the turned-on state.

It may be further understood that a voltage value of the first voltage and a voltage value of the second voltage, and a duration value of the fourth duration and a duration value of the fifth duration may be preconfigured in the inverter. Alternatively, a voltage value of the first voltage and a voltage value of the second voltage, and/or a duration value of the fourth duration and a duration value of the fifth duration may be indicated by the disturbance instruction. For example, the disturbance instruction may carry the third coefficient k₃, and the inverter may determine the voltage value of the first voltage and the voltage value of the second voltage based on the third coefficient k₃, and output the effective disturbance voltages.

It may be further understood that voltages at ports detected by the on/off-grid controller and the difference between the voltages at the two ends of the manual bypass circuit breaker K0 in this embodiment of this application may be effective voltages, that is, effective values of alternating current voltages.

In conclusion, this embodiment of this application provides the on/off-grid controller. On a premise that the on/off-grid relay is turned off, the control circuit in the on/off-grid controller can indicate the inverter to output the effective disturbance voltages. After the inverter outputs the effective disturbance voltages to the inverter-side port of the on/off-grid controller, the voltages at the inverter-side port fluctuate within a specific range. In this case, if detecting that the difference between the voltages at the two ends of the manual bypass circuit breaker is less than the second threshold, the control circuit can determine that the voltages at the power grid-side port can fluctuate, via the turned-on manual bypass circuit breaker, with fluctuation of the voltages at the inverter-side port. Therefore, the control circuit can accurately determine that the manual bypass circuit breaker is in the turned-on state, and send the alarm signal. The method for detecting turn-on can effectively avoid false detection, and ensure high accuracy of detecting the turned-on state of the manual bypass circuit breaker.

In addition, in the foregoing detection process, there is no need to control the on/off state of a detected relay (namely, the manual bypass circuit breaker), that is, no manual intervention is required. For a manual bypass circuit breaker that cannot be automatically controlled to be turned on or turned off through drive, a turned-on state of the manual bypass circuit breaker can be accurately detected.

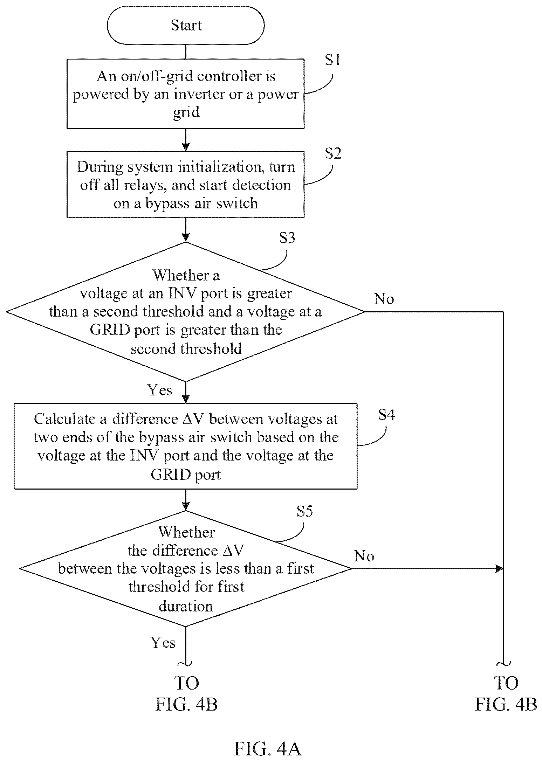

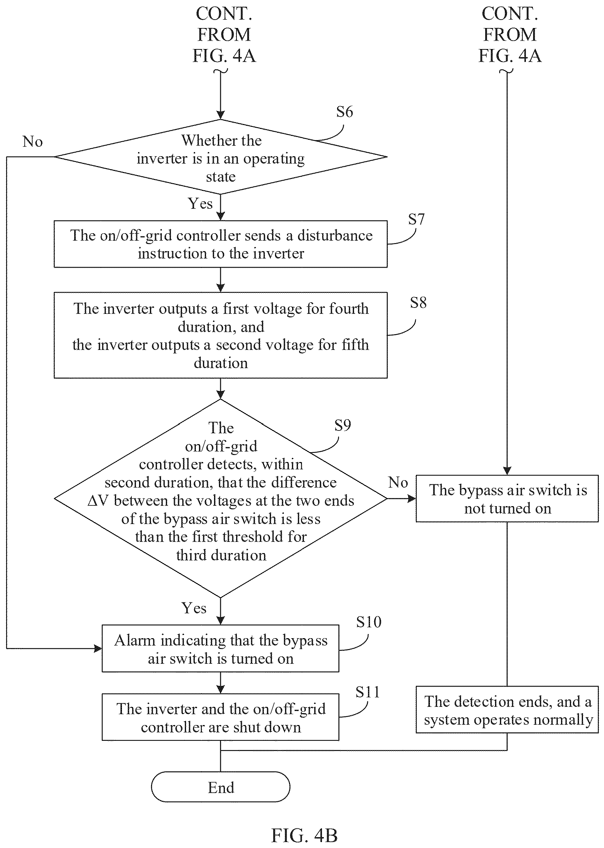

FIG. 4A and FIG. 4B are a flowchart of detecting turn-on of a manual bypass circuit breaker according to an embodiment of this application. The procedure for detecting turn-on is applied to the control circuit in the on/off-grid controller provided in the foregoing embodiments. As shown in FIG. 4A and FIG. 4B, the procedure for detecting turn-on of the manual bypass circuit breaker K0 may include the following steps.

Step S1: An on/off-grid controller is power by an inverter or a power grid.

Step S2: During system initialization, the on/off-grid controller turns off all relays, and starts the procedure for detecting turn-on of the manual bypass circuit breaker K0.

It may be understood that, during the system initialization, the on/off-grid controller may turn off an on/off-grid relay, for example, turn off an inverter-side relay and a power grid-side relay; and then, start the procedure for detecting turn-on of the manual bypass circuit breaker K0.

Step S3: The on/off-grid controller detects whether both a voltage at an inverter-side INV port and a voltage at a power grid-side GRID port are greater than a first threshold.

The first threshold may be k₁Uₙ, and Uₙ a rated voltage of the power grid. A first coefficient k₁ may be greater than 0 and less than 1. For example, the first coefficient k₁ may be 0.5. If both the voltage at the inverter-side INV port and the voltage at the power grid-side GRID port are greater than the first threshold, the on/off-grid controller may determine that the manual bypass circuit breaker K0 may be turned on, and continue to perform the following step S4. If either of the voltage at the inverter-side INV port and the voltage at the power grid-side GRID port is not greater than the first threshold, the on/off-grid controller may determine that the bypass switch K0 is not turned on, and stop the turn-on detection procedure, and a backup power system operates normally.

Step S4: The on/off-grid controller calculates a difference ΔV between voltages at two ends of the manual bypass circuit breaker K0 based on the voltage at the inverter-side INV port and the voltage at the power grid-side GRID port.

It may be understood that because the two ends of the manual bypass circuit breaker K0 are respectively connected to the inverter-side INV port and the power grid-side GRID port, a difference between voltages of the voltage at the inverter-side INV port and the voltage at the power grid-side GRID port is the difference ΔV between the voltages at the two ends of the manual bypass circuit breaker K0.

Step S5: The on/off-grid controller detects whether the difference ΔV between the voltages at the two ends of the manual bypass circuit breaker K0 is less than a second threshold for first duration.

The second threshold may be k₂Uₙ, and the value of a second coefficient k₂ may range from 0.01 to 0.1, for example, the second coefficient may be 0.02 or 0.04. A value of the first duration t1 may range from 2 seconds to 5 seconds, for example, the first duration t1 may be 3 seconds.

If the difference ΔV between the voltages at the two ends of the manual bypass circuit breaker K0 is less than the second threshold for the first duration, the on/off-grid controller may determine that the manual bypass circuit breaker K0 may be turned on, and continue to perform the following step S6. If the difference ΔV between the voltages at the two ends of the manual bypass circuit breaker K0 does not meet the foregoing condition, for example, the difference ΔV between the voltages is not less than the second threshold, or duration in which the difference ΔV between the voltages is less than the second threshold does not reach the first duration, the on/off-grid controller may determine that the bypass switch K0 is not turned on, and may stop the turn-on detection procedure, and the backup power system operates normally.

Step S6: The on/off-grid controller detects whether the inverter is in an operating state.

The operating state of the inverter may be transmitted by the inverter to the on/off-grid controller through an RS-485 bus and a photovoltaic system controller. Optionally, the operating state of the inverter may include an off-grid operating state, an on-grid operating state, and the like. It may be understood that, in step S2, because the on/off-grid controller has turned off the on/off-grid relay, the inverter is usually not in the on-grid operating state. In other words, the operating state is usually the off-grid operating state. It may be further understood that a non-operating state of the inverter may be a state in which the inverter stops performing power conversion, that is, the inverter does not output a voltage in a non-operating state.

In step S6, if detecting that the inverter is in the operating state, the on/off-grid controller may continue to perform the following step S7. If detecting that the inverter is in the non-operating state, the on/off-grid controller may determine that the bypass switch K0 is in a turned-on state. In other words, if detecting that the difference ΔV between the voltages at the two ends of the manual bypass circuit breaker K0 is less than the second threshold for the first duration, and the inverter is in the non-operating state, the on/off-grid controller may determine that the bypass switch K0 is in the turned-on state. Then, the on/off-grid controller may perform the following step S10.

Step S7: The on/off-grid controller delivers a disturbance instruction to the inverter.

For example, the on/off-grid controller may deliver the disturbance instruction (also referred to as a voltage disturbance instruction or a control instruction) to the inverter through the RS-485 bus and the photovoltaic system controller.

Step S8: The inverter outputs disturbance voltages.

After receiving the disturbance instruction, the inverter outputs the disturbance voltages. In other words, effective voltages of output voltages of the inverter can be disturbed within a small amplitude range. For example, the inverter may first output a first voltage for fourth duration, and then output a second voltage for fifth duration. An amplitude of the first voltage may be (1 + *k*₃)*Uₙ,* an amplitude of the second voltage may be (1 - *k*₃)*Uₙ,* and a third coefficient k₃ may be 0.05. The fourth duration and the fifth duration may be equal, for example, may be 3 seconds.

Step S9: The on/off-grid controller detects, within second duration after sending the voltage disturbance instruction, whether the difference ΔV between the voltages at the two ends of the manual bypass circuit breaker K0 is less than the second threshold for third duration.

It is assumed that a moment at which the voltage disturbance instruction is delivered is T0. The on/off-grid controller may continuously detect the difference ΔV between the voltages at the two ends of the manual bypass circuit breaker K0 within a detection time window from the moment T0 to a moment T1. Duration from the moment T0 to the moment T1 is the second duration t2. Within the detection time window, if the difference ΔV between the voltages at the two ends of the manual bypass circuit breaker K0 is less than the second threshold for the third duration t3, the on/off-grid controller may determine that the bypass switch K0 is in the turned-on state, and may perform the following step S10.

Within the detection time window, if the difference ΔV between the voltages at the two ends of the manual bypass circuit breaker K0 does not meet the foregoing condition, for example, if the difference ΔV between the voltages is not less than the second threshold, or the duration in which the difference ΔV between the voltages is less than the second threshold does not reach the third duration t3, the on/off-grid controller may determine that the bypass switch K0 is not turned on, and may stop the turn-on detection procedure, and the backup power system operates normally.

It may be understood that the third duration t3 is less than the second duration t2, and is greater than the fourth duration t4 and the fifth duration t5. For example, the second duration t2 may be 10 seconds, and a value of the third duration t3 may range from 5 to 10 seconds, for example, the third duration t3 may be 6 seconds.

Step S10: The on/off-grid controller sends an alarm indicating that the manual bypass circuit breaker K0 is turned on.

After determining, based on determining in step S6 or step S9, that the manual bypass circuit breaker K0 is in the turned-on state, the on/off-grid controller may send an alarm signal. The alarm signal indicates that the manual bypass circuit breaker K0 is turned on.

Step S11: The inverter and the on/off-grid controller are shut down.

After step S10, the on/off-grid controller may further report a shutdown instruction to the photovoltaic system controller, so that the photovoltaic system controller delivers the shutdown instruction to the inverter. The inverter may further be shut down according to the shutdown instruction. In other words, the inverter may stop outputting power. In addition, the on/off-grid controller may also be shut down after sending the alarm signal and the shutdown instruction. In other words, the on/off-grid relay in the on/off-grid controller may remain in a turned-off state.

It may be understood that a sequence of the foregoing steps may be appropriately adjusted, and the steps may be correspondingly increased or decreased based on a situation. For example, a sequence of step S3, step S5, and step S6 may be adjusted based on a situation. For example, step S5 may be performed before step S3, or step S6 may be performed before step S5.

An embodiment of this application further provides a method for detecting turn-on of a manual bypass circuit breaker. The method is applied to the backup power system provided in the foregoing embodiments. The method includes the following steps.

Step 101: Detect a voltage at an inverter-side port, a voltage at a power grid-side port, and an operating status of an inverter.

Step 102: When an on/off-grid relay is turned off, if both the voltage at the inverter-side port and the voltage at the power grid-side port are greater than a first threshold, a difference between voltages at two ends of the manual bypass circuit breaker is less than a second threshold, and the inverter is in a non-operating state, send an alarm signal, where
the alarm signal indicates that the manual bypass circuit breaker is in a turned-on state. The difference between the voltages at the two ends of the manual bypass circuit breaker is equal to a difference between the voltage at the inverter-side port and the voltage at the power grid-side port. In addition, the first threshold is greater than the second threshold.

Optionally, step 102 may include sending the alarm signal if both the voltage at the inverter-side port and the voltage at the power grid-side port are greater than the first threshold, duration in which the difference between the voltages at the two ends of the manual bypass circuit breaker is less than the second threshold reaches first duration, and the inverter is in the non-operating state.

Optionally, after step 102, the method may further include the following steps.

Step 103: Control the on/off-grid relay to remain in a turned-off state. That is, after it is detected that the manual bypass circuit breaker is in the turned-on state, the on/off-grid controller is controlled to be shut down.

Step 104: Send a shutdown instruction to the inverter.

Step 105: The inverter is shut down according to the shutdown instruction.

Optionally, step 101 to step 104 may be performed by a control circuit in the on/off-grid controller. In addition, the control circuit can further receive a status indication signal delivered by the inverter, and detect an operating status of the inverter based on the status indication signal.

An embodiment of this application further provides another method for detecting turn-on of a manual bypass circuit breaker. The method is applied to the backup power system provided in the foregoing embodiment. The method includes the following steps.

Step 201: Detect a voltage at an inverter-side port, a voltage at a power grid-side port, and an operating status of an inverter.

Step 202: When an on/off-grid relay is turned off, if detecting that both the voltage at the inverter-side port and the voltage at the power grid-side port are greater than a first threshold and the inverter is in an operating state, send a disturbance instruction to the inverter.

Step 203: The inverter controls, according to the disturbance instruction, effective voltages output by the inverter to be sequentially a first voltage and a second voltage.

The first voltage is different from the second voltage. In other words, the inverter can control, according to the disturbance instruction, effective voltages output by the inverter to be disturbed within a specific range.

Step 204: Detect a difference between voltages at two ends of the manual bypass circuit breaker after sending the disturbance instruction.

Step 205: Send an alarm signal if the difference between the voltages at the two ends of the manual bypass circuit breaker is less than a second threshold, where the alarm signal indicates that the manual bypass circuit breaker is in a turned-on state.

Optionally, step 202 may include: when the on/off-grid relay is turned off, if detecting that both the voltage at the inverter-side port and the voltage at the power grid-side port are greater than the first threshold, the difference between the voltages at the two ends of the manual bypass circuit breaker is less than the second threshold, and the inverter is in the operating state, sending the disturbance instruction to the inverter.

Optionally, step 202 may include: when the on/off-grid relay is turned off, if detecting that both the voltage at the inverter-side port and the voltage at the power grid-side port are greater than the first threshold, duration in which the difference between the voltages at the two ends of the manual bypass circuit breaker is less than the second threshold reaches first duration, and the inverter is in the operating state, sending the disturbance instruction to the inverter.

Optionally, step 205 may include sending, within second duration after sending the disturbance instruction, the alarm signal if detecting that duration in which the difference between the voltages at the two ends of the manual bypass circuit breaker is less than the second threshold reaches third duration; and the second duration is greater than the third duration.

Optionally, the disturbance instruction may indicate that duration of the first voltage output by the inverter is fourth duration, and duration of the second voltage is fifth duration, where the first voltage is different from the second voltage, and the third duration is greater than the fourth duration and greater than the fifth duration.

Optionally, after step 205, the method may further include the following steps.

Step 206: Control the on/off-grid relay to remain in a turned-off state. In other words, after detecting that the manual bypass circuit breaker is in the turned-on state, a control circuit may control an on/off-grid controller to shut down.

Step 207: Send a shutdown instruction to the inverter.

Step 208: The inverter is shut down according to the shutdown instruction.

Optionally, step 201 and step 202, and step 204 to step 207 may be performed by the control circuit in the on/off-grid controller. In addition, the control circuit can further receive a status indication signal delivered by the inverter, and detect an operating status of the inverter based on the status indication signal.

It can be understood that the method for detecting turn-on of the manual bypass circuit breaker has a basic same implementation and technical effect as the on/off-grid controller provided in the foregoing embodiments. Therefore, for brevity, an implementation and technical effect of the method for detecting turn-on of the manual bypass circuit breaker are not described herein again.

An embodiment of this application further provides a backup power system. As shown in FIG. 1 and FIG. 2, the backup power system includes an inverter and the on/off-grid controller provided in the foregoing embodiments.

The inverter is connected to an inverter-side INV port of the on/off-grid controller, and a power grid-side GRID port of the on/off-grid controller is configured to connect to a power grid. The inverter is configured to send a status indication signal to the on/off-grid controller. The status indication signal indicates that the inverter is in an operating state or a non-operating state.

Optionally, the inverter is further configured to: when being in the operating state, if receiving a disturbance instruction delivered by the on/off-grid controller, control, according to the disturbance instruction, effective voltages output by the inverter to be sequentially a first voltage and a second voltage, where the first voltage is different from the second voltage.

Optionally, duration of the first voltage output by the inverter is fourth duration, and duration of the second voltage is fifth duration.

In embodiments of this application, the terms "first", "second", and "third" are merely used for description, but shall not be understood as an indication or implication of relative importance. The term "at least one" means one or more, and "a plurality of" means two or more.

The term "and/or" in this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

The foregoing descriptions are merely optional implementations of this application, but the protection scope of this application is not limited thereto. Any equivalent modification or replacement readily figured out by a person skilled in the art within the technical scope disclosed in this application shall fall within the protection scope of this application. Therefore, the protection scope of this application shall be subject to the protection scope of the claims.

## Claims

1. A backup power system, wherein the backup power system comprises an inverter and an on/off-grid controller; an inverter-side port of the on/off-grid controller is connected to the inverter, a power grid-side port of the on/off-grid controller is configured to connect to a power grid, and the on/off-grid controller comprises an on/off-grid relay, a manual bypass circuit breaker, and a control circuit;
the on/off-grid relay is connected between the inverter-side port and the power grid-side port, the manual bypass circuit breaker is connected between the inverter-side port and the power grid-side port, and the control circuit is separately connected to the inverter-side port, the power grid-side port, the inverter, and the on/off-grid relay;
the inverter is configured to send a status indication signal to the control circuit, wherein the status indication signal indicates that the inverter is in an operating state or a non-operating state; and
the control circuit is configured to: detect a voltage at the inverter-side port and a voltage at the power grid-side port, and when the on/off-grid relay is turned off, if both the voltage at the inverter-side port and the voltage at the power grid-side port are greater than a first threshold, a difference between voltages at two ends of the manual bypass circuit breaker is less than a second threshold, and the inverter is in the non-operating state, send an alarm signal, wherein the alarm signal indicates that the manual bypass circuit breaker is in a turned-on state.

2. The backup power system according to claim 1, wherein the control circuit is configured to send the alarm signal if both the voltage at the inverter-side port and the voltage at the power grid-side port are greater than the first threshold, duration in which the difference between the voltages at the two ends of the manual bypass circuit breaker is less than the second threshold reaches first duration, and the inverter is in the non-operating state.

3. The backup power system according to claim 1 or 2, wherein the control circuit is further configured to: control, based on the manual bypass circuit breaker being in the turned-on state, the on/off-grid relay to remain in a turned-off state, and send a shutdown instruction to the inverter; and
the inverter is configured to shut down according to the shutdown instruction.

4. The backup power system according to any one of claims 1 to 3, wherein the inverter-side port of the on/off-grid controller is further configured to connect to a backup load, and the power grid-side port of the on/off-grid controller is further configured to connect to a non-backup load.

5. The backup power system according to any one of claims 1 to 4, wherein the first threshold is k₁Uₙ, and the second threshold is k₂Uₙ; and
*Uₙ* is a rated voltage of the power grid, k₁ is a first coefficient, k₂ is a second coefficient, a value of the second coefficient ranges from 0.01 to 0.1, and the first coefficient is greater than the second coefficient and less than 1.

6. A backup power system, wherein the backup power system comprises an inverter and an on/off-grid controller; an inverter-side port of the on/off-grid controller is connected to the inverter, a power grid-side port of the on/off-grid controller is configured to connect to a power grid, and the on/off-grid controller comprises an on/off-grid relay, a manual bypass circuit breaker, and a control circuit;
the on/off-grid relay is connected between the inverter-side port and the power grid-side port, the manual bypass circuit breaker is connected between the inverter-side port and the power grid-side port, and the control circuit is separately connected to the inverter-side port, the power grid-side port, the inverter, and the on/off-grid relay;
the inverter is configured to send a status indication signal to the control circuit, wherein the status indication signal indicates that the inverter is in an operating state or a non-operating state;
the control circuit is configured to: detect a voltage at the inverter-side port and a voltage at the power grid-side port, and when the on/off-grid relay is turned off, if detecting that both the voltage at the inverter-side port and the voltage at the power grid-side port are greater than a first threshold and the inverter is in the operating state, send a disturbance instruction to the inverter;
the inverter is further configured to control, according to the disturbance instruction, effective voltages output by the inverter to be sequentially a first voltage and a second voltage, wherein the first voltage is different from the second voltage; and
the control circuit is further configured to: detect a difference between voltages at two ends of the manual bypass circuit breaker after sending the disturbance instruction, and send an alarm signal if the difference between the voltages is less than a second threshold, wherein the alarm signal indicates that the manual bypass circuit breaker is in a turned-on state.

7. The backup power system according to claim 6, wherein the control circuit is configured to: when the on/off-grid relay is turned off, if detecting that both the voltage at the inverter-side port and the voltage at the power grid-side port are greater than the first threshold, the difference between the voltages at the two ends of the manual bypass circuit breaker is less than the second threshold, and the inverter is in the operating state, send the disturbance instruction to the inverter.

8. The backup power system according to claim 7, wherein the control circuit is configured to: when the on/off-grid relay is turned off, if detecting that both the voltage at the inverter-side port and the voltage at the power grid-side port are greater than the first threshold, duration in which the difference between the voltages at the two ends of the manual bypass circuit breaker is less than the second threshold reaches first duration, and the inverter is in the operating state, send the disturbance instruction to the inverter.

9. The backup power system according to any one of claims 6 to 8, wherein the control circuit is configured to send, within second duration after sending the disturbance instruction, the alarm signal if detecting that duration in which the difference between the voltages at the two ends of the manual bypass circuit breaker is less than the second threshold reaches third duration; and
the second duration is greater than the third duration.

10. The backup power system according to claim 9, wherein duration of the first voltage is fourth duration, and duration of the second voltage is fifth duration; and
the third duration is greater than the fourth duration and greater than the fifth duration.

11. The backup power system according to any one of claims 6 to 10, wherein the first voltage is (1 + *k*₃)*Uₙ,* and the second voltage is (1 - *k*₃)*Uₙ*; and
*Uₙ* is a rated voltage of the power grid, k₃ is a third coefficient, and the third coefficient is greater than 0 and less than or equal to 0.2.

12. The backup power system according to any one of claims 6 to 11, wherein the control circuit is further configured to: control, based on the manual bypass circuit breaker being in the turned-on state, the on/off-grid relay to remain in a turned-off state, and send a shutdown instruction to the inverter; and
the inverter is further configured to shut down according to the shutdown instruction.

13. The backup power system according to any one of claims 6 to 12, wherein the inverter-side port of the on/off-grid controller is further configured to connect to a backup load, and the power grid-side port of the on/off-grid controller is further configured to connect to a non-backup load.

14. A method for detecting turn-on of a manual bypass circuit breaker, wherein the method comprises:
detecting a voltage at an inverter-side port of a on/off-grid controller, a voltage at a power grid-side port, and an operating status of an inverter; and
when a on/off-grid relay is turned off, if both the voltage at the inverter-side port and the voltage at the power grid-side port are greater than a first threshold, a difference between voltages at two ends of the manual bypass circuit breaker is less than a second threshold, and the inverter is in a non-operating state, sending an alarm signal, wherein the alarm signal indicates that the manual bypass circuit breaker is in a turned-on state.

15. A method for detecting turn-on of a manual bypass circuit breaker, wherein the method comprises:
detecting a voltage at an inverter-side port of a on/off-grid controller, a voltage at a power grid-side port, and an operating status of an inverter; and
when an on/off-grid relay is turned off, if detecting that both the voltage at the inverter-side port and the voltage at the power grid-side port are greater than a first threshold and the inverter is in an operating state, sending a disturbance instruction to the inverter;
controlling, by the inverter according to the disturbance instruction, effective voltages output by the inverter to be sequentially a first voltage and a second voltage, wherein the first voltage is different from the second voltage; and
sending an alarm signal if detecting that a difference between voltages at two ends of the manual bypass circuit breaker is less than a second threshold after sending the disturbance instruction, wherein the alarm signal indicates that the manual bypass circuit breaker is in a turned-on state.
